# EUROPEAN PATENT APPLICATION

(11) **EP 1 630 865 A1**
(43) Date of publication of application: **01.03.2006**
(21) Application number: 04103945.4
(22) Date of filing: 17.08.2004
(51) Int. Cl.: H01L 23/495, H01L 21/58

(54) **Adhesion of a Chip on a leadframe**

(71) Applicant: OPTIMUM CARE INTERNATIONAL TECH. INC., Neihu District, Taipei City 114 (TW)
(72) Inventor: Lien, Jeffrey, District 111, Taipei City, Taiwan (CN)
(74) Representative: Schmitz, Jean-Marie

(57) **Abstract**

A chip fixed structure which is aiming at the better design of the adhesive body between the chip and the finger of the lead frame as well as its composite structure, which is to make said adhesive body with adhesion to form the stripe shapes with its width relatively smaller than the finger, through this to paste & settles a plurality of adhesive body on the upper lead facet of its dual-arrows or four-arrows fingers, also makes a chip pasting on the adhesive body which makes each arrow of lead frame carrying a chip and composite a fixed adhesive structure, so that it forms a structure with its width relatively smaller than the lead frame through said adhesive body as well as its composite formation, which allows the physical or chemical influences by the temperature change, thus maintaining the quality of chip as well as its usage lives.

## Description

### BACKGROUND OF THE INVENTION

### 1. Field of the invention

The invention relates to a chip fixed structure, which refers to a kind of a chip fixed structure that is capable of preventing the chip being damaged by the influence of the adhesive body and thus achieving the benefit of material cost reduction.

### 2. Description of the Related Art:

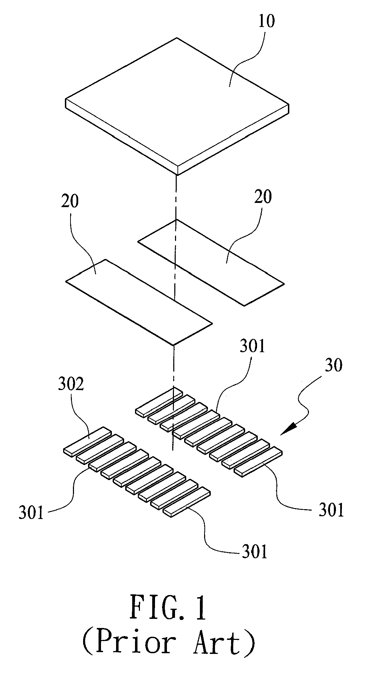

Accordingly, the assembly and the fixed structure of the conventional chip & the lead frame is shown in Fig. 1, which is to paste a chip (10) that is to be planned to design with an integrated circuit beforehand and to be spitted from the wafer upon the upper facet of each finger (301) of the lead frame (30) fixedly through a thin sheet shaped adhesive film (20), wherein it loads a chip (10) together with a plurality of finger (301), through said to make said chip (10) completes the fixed assembly structure with the lead frame (30), which becomes the outer electric conduction structure of said chip (10), so that it processes the subsequent welding process of the gold lines as well as encapsulation work, etc.

As shown in figure 1, the conventional adhesive film (20) is pasted upon the upper position of each finger (301) of the lead frame (30) which is to make the shape of said adhesive film (20) corresponds exactly on the total area formed by dual or quad rows of the finger (301), it utilizes an adhesive film (20) to cover the upper lead facet (302) of the finger (301), through this to paste a chip (10) on the adhesive film (20); thus, there not only is the condition of over-usage of the adhesive film (20), for example, it is needless to use the adhesive film (20) if there is no need to use the spatial portions of the loading chip (10) with the finger (301); besides, when the chip (10) operates and warm-up or is at low temperature, usually there is the phenomena of shrink or distortion or deformation, thus, in contract there is large shrink or deformation conditions for the conventional adhesive film (20) structure which corresponds completely the shape of the area shape of the total row of finger (301), thus it is easily to damage its upper chip (10).

### SUMMARY OF THE INVENTION

The main object of the invention is to provide a chip fixed-assembled structure better design wherein it is a kind of chip fixed-assembled structure better design that is used in the application of chip assembly and encapsulation process which is capable of preventing the chip being damaged by the influence of the adhesive body and thus achieving the benefit of material cost reduction

In accordance with the above-mentioned object, the content of practice of the invention first makes said adhesive body with adhesion forms the stripes shapes with its width slightly smaller than the finger beforehand, through this there pastes at least one adhesive body on the upper lead facet of dual-row or quad-row finger of the lead frame, and also a chip paste on one adhesive body such that each row of finger carry a chip and composite a fixed structure so that there forms a structure with its width slightly smaller than the finger through said adhesive body and the composition states, which lowers the influence of the physical or chemical change due to temperature alterations, such as to prevent the loss of a chip due to shrink upon heat, wrinkle and distortion or loss its viscosity.

### BRIEF DESCRIPTION OF THE DRAWINGS

Figure 1 is the illustrative figure of the conventional chip paste & fixed assemble structure.
Figure 2 is the decomposed illustrative figure of the chip fixed assembles structure of the invention.
Figure 3 is the top-view illustrative figure of the fixed assembles structure of the invention.
Figure 4 is another illustrative drawing of the pasting of the adhesive body of the invention.
Figure 5 is another illustrative drawing of the pasting of the adhesive body of the invention.
Figure 6 is another illustrative drawing of the pasting of the adhesive body of the invention.
Figure 7 is another illustrative drawing of the lead frame finger of the invention.

### DETAILED DESCRIPTION OF THE PREFERRED EMBODIMENT

The function, character and object of the structure of the invention are illustrated in detail with the structure character & others of the invention in accordance with the appended preferred embodiments:

As shown in the attached figure, the invention is a kind of " a chip fixed-assemble structure" design comprising at least a chip (1), a lead frame (2) and an adhesive body (3). Since chip (1) is a conventional object, so there is needless to tell the story about its detail structure, wherein:

Lead frame (2), please refers to figure (2), which is a metal device that have outward electric conductivity of the chip (1). It comprises the dual rows, quad rows or the even rows block shaped finger (21) which corresponds the chip (1) or the circuit board, which let a plurality of block finger (21) forms an upper lead facet (211) respectively that is capable of carrying the chip (1), also there settles a guiding facet (212) on the lower end to be the portion of connecting electric conductivity of chip (1) and the equipments such as the outer circuit boards;

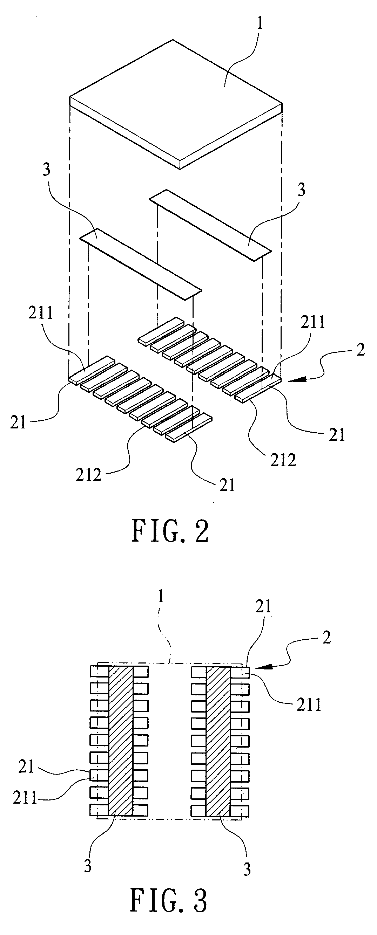

An adhesive body (3), please refer to figure 2, which is a stripe shaped thin-film sheet body with adhesion on its double sides comprising such as the double-sided glue or the film composite by coating the glues and cured, however, the shape and width of the adhesive body could be made to be just smaller than the length of the finger (21) of the above-mentioned lead frame (2);

Through such, as illustrated in fig. 2 and fig. 3, to pick the lead frame (2) wherein there pastes or coats to be a stripe adhesive body (3) on the upper facet (211) of each row of finger (21) and let the width and shape of the adhesive body (3) smaller than the length of the finger (21), which makes the inner portion or the outer portion of each finger (21) forms the states without adhesive body, also pastes a chip (1) on said adhesive body (3) and on the finger (21) which composites a fixed assemble structure of the chip (1) and the lead frame (2) of the invention for further golden lines connection or the encapsulation processing...etc.

By the chip fixed assemble structure, since there forms a state of which the adhesive body (3) is pasted or coated slightly smaller than the width of the finger, that is to say there is not pasted fully toward each row of finger (21), if it is, there is not only the function of adhesive & pasting the chip (1), but also the benefit of lowering the cost since the width and shape of the adhesive body (3) is well-controlled; in addition, since the width & shape of said stripe shaped adhesive body (3) is slightly smaller than the length of the finger (21), so the influence of physical or chemical variation caused due to the temperature alteration upon warm-up or low temperatures by the application of chip (1) such as reducing the occurrence of shrink, twist or losing adhesion of the adhesive body (3), so it could better the condition of chip damage fully caused by the conventional fully pasting the films, thus guarantee the quality of the chip (1) as well as its usage lives.

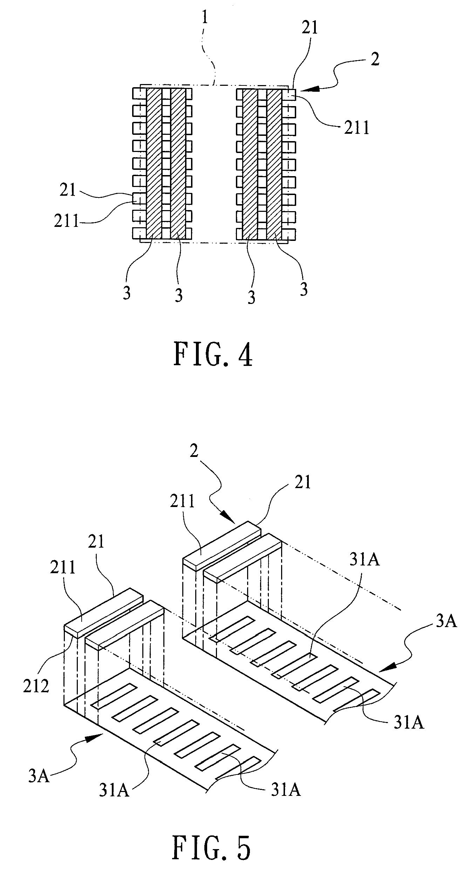

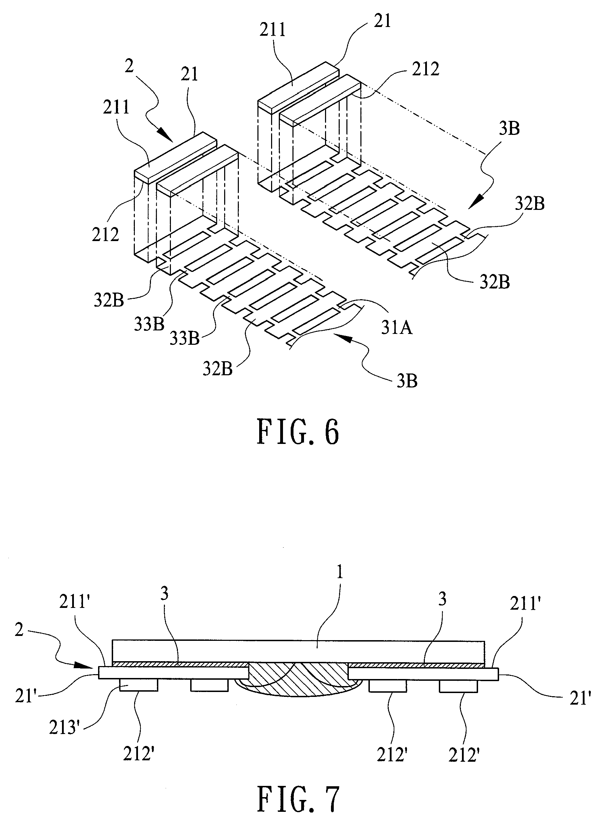

As the above-mentioned, the character of the invention is to paste a stripe shaped adhesive body (3) and smaller in width & shape on the upper lead facet (211) of the finger (21), wherein the state of the preferred embodiment comprising, as shown in figure 4, which could pick-up the upper facet (211) of each row of finger (21) of the lead frame (2) that pastes or coats dual adhesive bodies, let the width and shape of said adhesive body (3) smaller than the length of said finger (21), let the inner portion and outer portion of each finger (21) forms the state of no-adhesive body, through such to provide the upper pasting & fixing a chip (1); next it is shown as in figure 5, which, except for let the width & shape of said stripe shaped adhesive body (3A) slightly smaller than the length of finger (21), also there settles a divesting hollow portion (31A) on its slit corresponding to each finger (21), (It is coating with the glues and hollow portion natural forming.), through such to let said adhesive body (3A) just corresponds to the upper lead facet (211) of the finger (21) which removes other excess adhesive body (3A), if thus, it could further prevent the chip damage of shrink caused upon warming or the distortion deformation; on the same reasons, please refers to fig. 6, there could also settles a plurality of pasting portion structure state of which corresponds to the upper facet (211) of the finger (21) the stripe shaped adhesive body (3B) of the invention (double facet glues or glue films) while the width and shape is slightly smaller, through such pickup there settles at least a plurality of the connecting portion (33B) between each pasting portion (32B) to composite the adhesive body (3B) with stripe shaped, so it also could prevent the chip damage caused by shrink or distortion deformation upon warming of said adhesive body (3A); thus, those who comprises the pasting structure of length for those whose width & shape smaller than the length of the finger (21) for the above-mentioned adhesive body (3) are comprised by the above-mentioned technology character of the invention.

Besides, a plurality of finger (21) of said lead frame (2) of the invention is not confined by the above-mentioned rectangular shaped block structure, as shown in figure 7, which could also be a finger (21') structure wherein there settles an upper lead facet (211') on its upper end, there settles a bump (213') on its lower end, also by means of the bump (213') to be the finger (21') structure of the guiding facet (212'), also whereby said bump (213') could also be composite via alternate interlacing arrangement through which to be the guiding end of the circuit boards or the other equipments, so it is pointed that those whose finger states of which forms the states of an upper lead facet (21), (21') for pasting the adhesive body (3, 3A, 3B) should be included in the above-mentioned technology character and the claims of the invention.

To sum up, the "a chip fixed assemble structure" design of the invention has both practicability & novel ness, which effects & design object conforms to reasonably progress which is clear. Thus, it is appended the patent application according to the patent law, which we wish your bureau could approval for said patent to encourage the novel ness.

## Claims

1. A chip fixed assemble structure comprising the chip, the lead frame and the adhesive body, wherein:
Lead frame, which is the metal device for outer electric conduction outwardly comprising a plurality of block shaped finger structure that makes each finger, forms a upper lead facet on its upper portion that could carry a chip;
Adhesive body, which is a stripe shaped thin film body with its adhesion on its double facet, which also makes its width & shape exactly smaller than the length of finger of the lead frame;
By means of this, to select the lead frame wherein there settles at least an adhesive body on each row finger upper lead facet, let the width and the shape of the adhesive body smaller slightly than the length of the finger, also to paste a chip on said adhesive body and said finger to let said adhesive body fixed on said chip to assemble said chip fixed structure of assembly.

2. The chip fixed structure betterment as mentioned in claim 1, wherein said adhesive body comprises the glue film that utilizes the coating of the double-facet glue or adhesive glues and cured.

3. The chip fixed structure betterment as mentioned in claim 1, wherein the upper lead facet of each row finger comprises settles at least two adhesive bodies.

4. The chip fixed structure betterment as mentioned in claim 1, wherein said adhesive body comprises the settlement of the hollow portion corresponding to the silt position of each finger.

5. The chip fixed structure betterment as mentioned in claim 1, wherein said adhesive body comprises settling a plurality of the upper lead facet of finger in correspondence while the width & shape is smaller than the pasting portion of the finger length, also there selects each pasting portion wherein there settles at least a connecting portion within.

6. The chip fixed structure betterment as mentioned in claim 1, wherein said finger comprises to settle a bump, also there utilizes the bottom of the bump to be the guiding connection structure.

7. The chip fixed structure betterment as mentioned in claim 1, wherein said adhesive body comprises the means wherein there is glues coated above.
